(19) Europäisches Patentamt

European Patent Office

Office européen des brevets

(11) **EP 1 304 580 A2**

(12) **EUROPÄISCHE PATENTANMELDUNG**

(43) Veröffentlichungstag:
**23.04.2003 Patentblatt 2003/17**

(51) Int Cl.[7]: **G01R 31/08**

(21) Anmeldenummer: **02018543.5**

(22) Anmeldetag: **17.08.2002**

(84) Benannte Vertragsstaaten:
**AT BE BG CH CY CZ DE DK EE ES FI FR GB GR IE IT LI LU MC NL PT SE SK TR**
Benannte Erstreckungsstaaten:
**AL LT LV MK RO SI**

(30) Priorität: **19.10.2001 DE 10151775**

(71) Anmelder: **Alstom**
**75795 Paris Cedex 16 (FR)**

(72) Erfinder:
• **Eberl, Gerit, Dipl.-Ing.**
**01099 Dresden (DE)**
• **Schegner, Peter, Prof. Dr.-Ing.**
**01259 Dresden (DE)**

(74) Vertreter: **Dreiss, Fuhlendorf, Steimle & Becker**
**Patentanwälte,**
**Postfach 10 37 62**
**70032 Stuttgart (DE)**

(54) **Verfahren zur Berechnung der Distanz zum Fehlerort eines einpoligen Erdfehlers in einem Energieversorgungsnetz**

(57) Es wird ein Verfahren zur Berechnung einer Distanz (1) eines Fehlerorts (F) eines einpoligen Erdfehlers von einem Messort (M) in einem elektrischen Energieversorgungsnetz beschrieben. Es werden Leiter-Erde-Spannungen ($U_R$, $U_S$, $U_T$) und Leiterströme ($I_R$, $I_S$, $I_T$) im Messort (F) gemessen. Es werden eine Nullspannung ($U_0$) und ein Nullstrom ($I_0$) gemessen oder berechnet. Es werden daraus symmetrische Spannungen ($U_1$, $U_2$) und symmetrische Ströme ($I_1$, $I_2$) des Mitsystems und des Gegensystems berechnet. Es werden daraus ein symmetrischer Nullstrom ($I_{OS}$) und ein Fehlerstrom ($I_F$) berechnet. Es werden die Messungen unter veränderten Bedingungen wiederholt, um daraus Differenzgrößen der Spannungen und Ströme zu berechnen. Es wird daraus die Distanz (1) des Fehlerorts (F) von dem Messort (M) berechnet.

Fig. 1

EP 1 304 580 A2

**Beschreibung**

Stand der Technik

Die Erfindung geht aus von einem Verfahren zur Berechnung einer Distanz eines Fehlerorts eines einpoligen Erdfehlers von einem Messort in einem elektrischen Energieversorgungsnetz, insbesondere in einem kompensiert betriebenen Energieversorgungsnetz. Die Erfindung betrifft ebenfalls ein entsprechendes elektrisches Energieversorgungsnetz mit einem Rechengerät zur Durchführung des Verfahrens.

Bei bekannten Verfahren zur Ermittlung des Fehlerorts eines einpoligen Erdfehlers werden üblicherweise transiente Ausgleichsvorgänge nach dem Auftreten des Erdfehlers ausgewertet. Diese Ausgleichsvorgänge sind jedoch von dem Fehlerwiderstand des Erdfehlers abhängig, was zu Ungenauigkeiten dieser Verfahren führt. Ebenfalls können diese Verfahren bei ein- und demselben Erdfehler nicht mehrfach wiederholt werden.

Aufgabe der Erfindung ist es, ein Verfahren zur Berechnung einer Distanz eines Fehlerorts eines einpoligen Erdfehlers von einem Messort in einem elektrischen Energieversorgungsnetz zu schaffen, das eine höhere Genauigkeit aufweist.

Lösung und Vorteile der Erfindung

Diese Aufgabe wird erfindungsgemäß durch ein Verfahren nach dem Anspruch 1 gelöst.

Das erfindungsgemäße Verfahren basiert nicht auf transienten Ausgleichsvorgängen, sondern auf stationären Größen. Dies ermöglicht die Wiederholung von Messungen im Rahmen des Verfahrens, so dass dann die Differenzmethode zur Auswertung der gemessenen Größen angewendet werden kann. Die Anwendung der Differenzmethode bringt den wesentlichen Vorteil einer erhöhten Genauigkeit des erfindungsgemäßen Verfahrens mit sich. Weiterhin ist das erfindungsgemäße Verfahren aufgrund der Verwendung der Differenzmethode auch bei einem großen Fehlerwiderstand des Erdfehlers anwendbar. Zusätzlich wird durch den Einsatz der Differenzmethode eine verhältnismäßig hohe Unabhängigkeit von dem auf der Leitung vorhandenen Laststrom erreicht, so dass sich auch insoweit eine verbesserte Genauikeit ergibt.

Besonders vorteilhaft ist es, den Fehlerstrom aus der Differenz des Nullstroms und des symmetrischen Nullstroms zu berechnen. Dabei können die erforderlichen Spannungen und Ströme und die Nulladmittanz aus den sich ergebenden Größen der Differenzmethode abgeleitet werden.

Ein weiterer Vorteil besteht darin, dass die Differenzmethode durch eine einfache Änderung der Impedanz einer Erdschlussspule und den beiden daraus resultierenden unterschiedlichen Messdurchgängen realisiert werden kann.

Weitere Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

Ausführungsbeispiele der Erfindung

Figur 1    zeigt ein schematisches Ersatzschaltbild eines einpoligen Fehlers in einem elektrischen, kompensiert betriebenen Energieversorgungsnetz, und

Figur 2    zeigt eine schematische Darstellung eines Ausführungsbeispiels eines erfindungsgemäßen Verfahrens zur Berechnung der Distanz des einpoligen Fehlers von einem Messort.

Ein Energieversorgungsnetz, beispielsweise ein elektrisches Hochspannungsnetz, weist unter anderem eine Vielzahl von Überlandleitungen auf. Bei derartigen Überlandleitungen besteht die Möglichkeit, dass sogenannte Erdfehler auftreten. Diese können z.B. durch einen mit der Überlandleitung in Kontakt kommenden Baum entstehen, über den dann eine der Phasen des Hochspannungsnetzes einen Kurzschluss nach Erde aufweist.

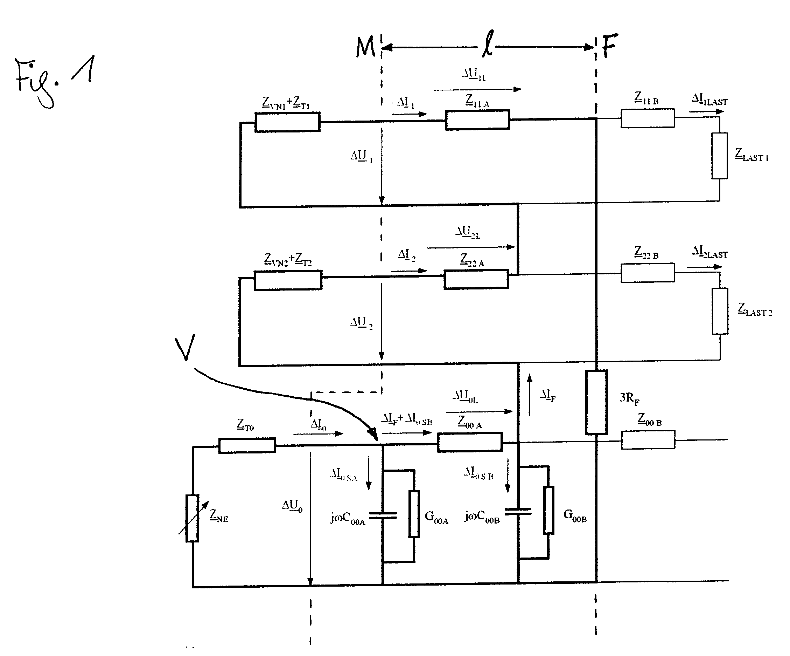

Figur 1 zeigt das Ersatzschaltbild des kompensiert betriebenen Hochspannungsnetzes nach dem Auftreten eines derartigen Erdfehlers.

In der Figur 1 ist - von oben nach unten - das Mitsystem, das Gegensystem und das Nullsystem des Hochspannungsnetzes dargestellt. Bei allen drei Systemen wird davon ausgegangen, dass sich links beispielsweise ein Umspannwerk und rechts eine Last befindet. Dazwischen verläuft z.B. die Überlandleitung.

In allen drei Systemen sind links Transformatorimpedanzen $Z_{T1}$, $Z_{T2}$, $Z_{T0}$ vorhanden. In dem Mitsystem und dem Gegensystem sind Netzvorimpedanzen $Z_{VN1}$, $Z_{VN2}$ angegeben. Weiterhin ist bei dem Nullsystem die Impedanz $Z_{NE}$ einer Erdschlussspule angegeben, die veränderbar ist.

Rechts von den genannten Impedanzen ist ein Messort vorhanden, an dem Spannungen und Ströme tatsächlich gemessen werden können. Dieser Messort befindet sich z.B. innerhalb des Umspannwerks, möglichst unmittelbar vor dem Abgang auf die Überlandleitungen. Der Messort ist in der Figur 1 mit einer gestrichelten Linie und der Bezugsziffer M gekennzeichnet.

An dem Messort können die Leiter-Erde-Spannungen $U_R$, $U_S$, $U_T$, die Leiterströme $I_R$, $I_S$, $I_T$, sowie die Nullspannung $U_0$ und der Nullstrom $I_0$ gemessen werden. Bei der Nullspannung $U_0$ handelt es sich um diejenige Spannung, die von einem Sternpunkt der drei Phasen R, S, T des Hochspannungsnetzes gegen Erde vorhanden ist.

Die dem Messort M nachfolgende Überlandleitung ist durch die Leitungsimpedanzen $Z_{11A}$, $Z_{11B}$, $Z_{22A}$, $Z_{22B}$, $Z_{00A}$, $Z_{00B}$ charakterisiert.

Zwischen den beiden Leitungsimpedanzen $Z_{11A}$, $Z_{11B}$ des Mitsystems ist ein Fehlerwiderstand $R_F$ nach Erde geschaltet. Dieser Fehlerwiderstand $R_F$ repräsentiert z.B. den Baum, der den Erdfehler verursacht. Der Ort des Fehlerwiderstand $R_F$ stellt den Fehlerort dar und ist in der Figur 1 mit einer gestrichelten Linie und der Bezugsziffer F gekennzeichnet.

Die Leitungsimpedanzen sowie davon abgeleitete Größen links von dem Fehlerort F enthalten die Kennzeichnung A, während entsprechende Größen rechts von dem Fehlerort die Kennzeichnung B aufweisen.

In den drei Systemen ist rechts die an das Hochspannungsnetz angeschlossene Last dargestellt, und zwar durch die Lastimpedanzen $Z_{LAST1}$, $Z_{LAST2}$.

In dem Nullsystem ist die Nulladmittanz $Y_{00\text{-Leitung}}$ durch die Leitwerte $G_{00A}$, $G_{00B}$ und durch die Kapazitäten $C_{00A}$, $C_{00B}$ angegeben. Diese Nulladmittanz $Y_{00\text{-Leitung}}$ stellt dabei den Mittelwert der Admittanzen aller Phasen R, S, T gegen Erde dar. Die Kennzeichnungen A, B beziehen sich wiederum auf das Vorhandensein der Leitwerte bzw. Kapazitäten links und rechts von dem Fehlerort F.

Die Distanz zwischen dem Messort M und dem Fehlerort F ist in der Figur 1 mit der Bezugsziffer l gekennzeichnet.

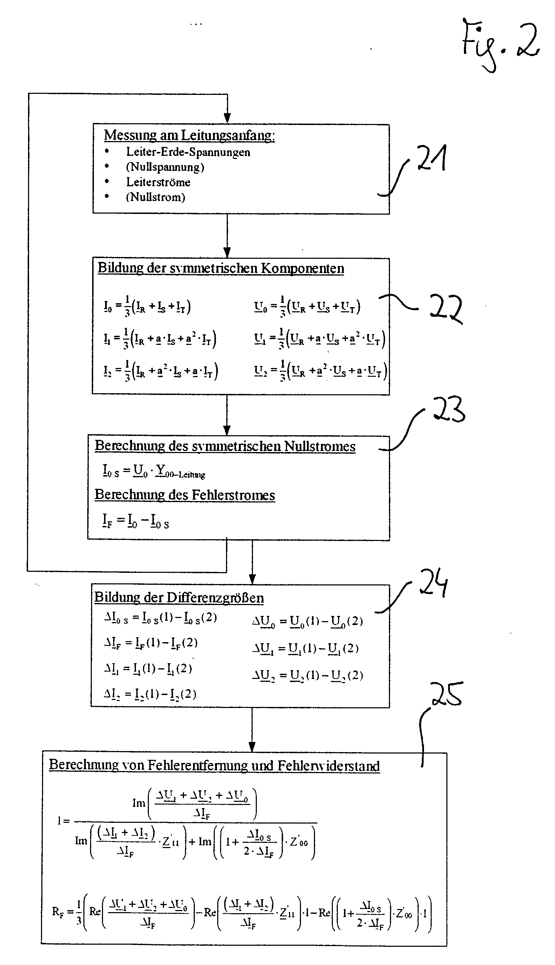

In der Figur 2 ist ein Verfahren dargestellt, mit dem die Distanz 1 des Fehlerorts F von dem Messort M berechnet werden kann. Dieses Verfahren kann bei Weiterführung des Betriebs des Hochspannungsnetzes durchgeführt werden.

Das Verfahren wird mit Hilfe eines Rechengeräts, beispielsweise eines Personalcomputers durchgeführt. Das Rechengerät ist vorzugsweise am Messort vorhanden.

In einem Schritt 21 werdendie Leiter-Erde-Spannungen $U_R$, $U_S$, $U_T$, die Leiterströme $I_R$, $I_S$, $I_T$, sowie die Nullspannung $U_0$ und der Nullstrom $I_0$ gemessen. Diese Messungen erfolgen dabei nach dem Abklingen von transienten Ausgleichsvorgängen. Es wird darauf hingewiesen, dass die Nullspannung $U_0$ und der Nullstrom $I_0$ theoretisch auch aus den Leiter-Erde-Spannungen $U_R$, $U_S$, $U_T$ und den Leiterströmen $I_R$, $I_S$, $I_T$ berechnet werden könnten. Dies ist in dem nachfolgend erläuterten Schritt angegeben.

In einem Schritt 22 werden aus den gemessenen Größen die zugehörigen symmetrischen Komponenten berechnet. Dabei handelt es sich um die Ströme $I_0$, $I_1$, $I_2$ und die Spannungen $U_0$, $U_1$, $U_2$ des Nullsystems, des Mitsystems und des Gegensystems. Die Berechnung stellt eine Transformation dar und wird in Abhängigkeit von den Leiter-Erde-Spannungen $U_R$, $U_S$, $U_T$ und den Leiterströmen $I_R$, $I_S$, $I_T$ durchgeführt. Die für die Transformation vorgesehen Gleichungen sind in dem Schritt 22 der Figur 2 angegeben. Der dort vorhandene Wert a ist eine bekannte, fest vorgegebene, komplexe Größe.

Wie bereits erwähnt wurde, können die Nullspannung $U_0$ und der Nullstrom $I_0$ des Nullsystems auch direkt gemessen werden.

In dem Ersatzschaltbild der Figur 1 ist eine Verzweigung V besonders hervorgehoben. Dort gelten für den in die Verzweigung V einfließenden Nullstrom $I_0$ folgende Gleichungen:

$$I_0 = I_F + I_{0S}$$

mit

$$I_{0S} = I_{0SA} + I_{0SB}.$$

Mit $I_F$ ist in diesen Gleichungen ein Fehlerstrom gekennzeichnet, während mit $I_{0S}$ ein symmetrischer Nullstrom eingeführt wird, der sich aus den links- und rechtsseitig von dem Fehlerort F hervorgerufenen Nullströmen $I_{0SA}$, $I_{0SB}$ zusammensetzt.

Der vorstehend genannte symmetrische Nullstrom entsteht dadurch, dass auf einer der Phasen des Hochspannungsnetzes eine Unsymmetrie z.B. aufgrund eines Erdfehlers vorhanden ist. Diese Unsymmetrie führt zu einer Nullspannung, die über der Nulladmittanz $Y_{00\text{-}Leitung}$ abfällt. Gemäß der Figur 1 setzt sich die Nulladmittanz $Y_{00\text{-}Leitung}$ dabei aus Admittanzen links und rechts des Fehlerorts F zusammen. Die abfallende Nullspanung hat dann die zugehörigen Nullströme $I_{0SA}$, $I_{0SB}$ zur Folge.

In einem nachfolgenden Schritt 23 werden der symmetrische Nullstrom $I_{0S}$ und der Fehlerstrom $I_F$ berechnet. Dies geschieht auf der Grundlage der vorstehenden Gleichungen und Erläuterungen sowie in Abhängigkeit von den in dem Schritt 23 angegebenen Gleichungen.

Die zu diesem Zweck erforderliche Nulladmittanz $Y_{00\text{-}Leitung}$ kann beispielsweise vorab mit Hilfe eines Verfahrens berechnet werden, bei dem im fehlerfreien Betrieb des Hochspannungsnetzes zwei unterschiedliche Messungen des Nullstroms $I_0$ und der Nullspannung $U_0$ durchgeführt werden, aus denen dann die Nulladmittanz $Y_{00\text{-}Leitung}$ durch Division berechnet werden kann.

Die vorstehend beschriebenen Schritte 21, 22, 23 werden bei einem ersten Wert der Impedanz $Z_{NE}$ der Erdschlussspule durchgeführt. Die erhaltenen Strom- und Spannungswerte werden gespeichert. Dann wird die Impedanz $Z_{NE}$ der Erdschlussspule auf einen zweiten Wert und damit auf unterschiedliche Bedingungen eingestellt. Dies kann durch eine direkte Verstimmung der Erdschlussspule oder auch durch das Zu- und/oder Abschalten zusätzlicher Blindschaltelemente im Sternpunkt vorgenommen werden.

Danach werden die Schritte 21, 22, 23 mit dem zweiten Wert der Impedanz $Z_{NE}$ der Erdschlussspule nochmals durchlaufen. Die erhaltenen Strom- und Spannungswerte werden wiederum gespeichert.

In einem nachfolgenden Schritt 24 werden Differenzgrößen aus den abgespeicherten Werten der beiden Messdurchgänge berechnet. Die Werte der beiden Messdurchgänge sind dabei in den Gleichungen, die in dem Schritt 24 der Figur 1 angegeben sind, durch die Klammerausdrücke (1), (2) voneinander unterschieden.

In dem Schritt 24 sind diejenigen Gleichungen der angewendeten Differenzmethode angegeben, die erforderlich sind, um die Differenzgrößen der beiden Messdurchgänge für den symmetrischen Nullstrom $I_{0S}$, den Fehlerstrom $I_F$, den Strom $I_1$ im Mitsystem, den Strom $I_2$ im Gegensystem, die Spannung $U_0$ im Nullsysstem, die Spannung $U_1$ im Mitsystem und die Spannung $U_0$ im Gegensystem zu berechnen.

In einem nachfolgenden Schritt 25 werden aus den vorstehend berechneten Differenzgrößen die Distanz l zwischen dem Messort M und dem Fehlerort F sowie der Fehlerwiderstand $R_F$ berechnet. Die hierfür vorgesehen Gleichungen sind in dem Schritt 25 angegeben. Dieser Berechnung liegt die Maschengleichung des Fehlerstromkreises der Ersatzschaltung der Figur 1 zugrunde. Diese lautet wie folgt:

$$\Delta \underline{U}_1 + \Delta \underline{U}_2 + \Delta \underline{U}_0 = (\Delta \underline{I}_1 + \Delta \underline{I}_2) \cdot \underline{Z}'_{11} \cdot 1 + \left(\Delta \underline{I}_F + \left(\Delta \underline{I}_F + \frac{1}{2}\Delta \underline{I}_{0S}\right) \cdot \underline{Z}'_{00} \cdot 1 + 3 \cdot \Delta \underline{I}_F \cdot R_F\right.$$

In der vorstehenden Maschengleichung ist die Annahme getroffen, dass die beiden Nullströme $I_{0SA}$, $I_{0SB}$ gleich groß, nämlich jeweils $1/2 \times I_{0S}$ sind. Diese Annahme ist erforderlich, da die Aufteilung der beiden Nullströme $I_{0SA}$, $I_{0SB}$ abhängig ist von dem Fehlerort F, dessen Ermittlung letztlich Ziel des beschriebenen Verfahrens ist. Die genannte Annahme hat zur Folge, dass die Berechnung der Distanz l einen geringfügigen Fehler aufweist.

In den beiden Gleichungen, die in dem Schritt 25 der Figur 2 angegeben sind, haben die Bezeichnungen Re und Im die Bedeutung von Realteilen und Imaginärteilen. Die dort ebenfalls angegebenen Impedanzen $Z'_{00}$ und $Z'_{11}$ stellen die auf eine Längeneinheit, z.B. auf einen Kilometer bezogenen Impedanzen der betroffenen Leitungen dar. Die Werte dieser bezogenen Impedanzen können mit Hilfe von Messungen beispielsweise bei der Inbetriebnahme des Hochspannungsnetzes oder auf der Grundlage der Geometrie des Hochspannungsnetzes oder mit Hilfe von Simulationen ermittelt werden. Die bezogenen Impedanzen $Z'_{00}$ und $Z'_{11}$ können damit als bekannt angenommen werden.

**Patentansprüche**

1. Verfahren zur Berechnung einer Distanz (l) eines Fehlerorts (F) eines einpoligen Erdfehlers von einem Messort (M) in einem elektrischen Energieversorgungsnetz, insbesondere in einem kompensiert betriebenen Energieversorgungsnetz, mit den folgenden Schritten: es werden Leiter-Erde-Spannungen ($U_R$, $U_S$, $U_T$) und Leiterströme ($I_R$, $I_S$, $I_T$) im Messort (F) gemessen, es werden eine Nullspannung ($U_0$) und ein Nullstrom ($I_0$) gemessen oder berechnet, es werden daraus symmetrische Spannungen ($U_1$, $U_2$) und symmetrische Ströme ($I_1$, $I_2$) des Mitsystems und des Gegensystems berechnet, es werden daraus ein symmetrischer Nullstrom ($I_{0S}$) und ein Fehlerstrom ($I_F$) berechnet, es werden die Messungen unter veränderten Bedingungen wiederholt, um daraus Differenzgrößen der Spannungen und Ströme zu berechnen, es wird daraus die Distanz (l) des Fehlerorts (F) von dem Messort (M) berechnet.

**2.** Verfahren nach Anspruch 1, bei dem der Fehlerstrom ($I_F$) aus der Differenz des Nullstroms ($I_0$) und des symmetrischen Nullstroms ($I_{0S}$) berechnet wird.

**3.** Verfahren nach einem der Ansprüche 1 oder 2, bei dem der symmetrische Nullstrom ($I_{0S}$) aus der Multiplikation der Nullspannung ($U_0$) und einer Nulladmittanz ($Y_{00\text{-Leitung}}$) berechnet wird.

**4.** Verfahren nach einem der Ansprüche 1 bis 3, bei dem die veränderten Bedingungen durch eine Änderung der Impedanz der Erdschlussspule ($Z_{NE}$) erreicht werden.

**5.** Verfahren nach einem der Ansprüche 1 bis 4, bei dem die Distanz (l) des Fehlerorts (F) von dem Messort (M) aus der Maschengleichung des Fehlerstromkreises abgeleitet wird.

**6.** Verfahren nach einem der Ansprüche 1 bis 5, bei dem aus den Differenzgrößen und der berechneten Distanz (l) zusätzlich ein Fehlerwiderstand ($R_F$) des einpoligen Erdfehlers berechnet wird.

**7.** Elektrisches Energieversorgungsnetz, insbesondere kompensiert betriebenes Energieversorgungsnetz, mit einem Messort (M), in dem Leiter-Erde-Spannungen ($U_R$, $U_S$, $U_T$) und Leiterströme ($I_R$, $I_S$, $I_T$) messbar sind, mit einem Fehlerort (M), in dem ein einpoliger Erdfehler vorhanden ist, und mit einem Rechengerät zur Durchführung des Verfahrens nach einem der vorstehenden Ansprüche.

EP 1 304 580 A2

Fig. 1

. . .

Fig. 2

```
┌─────────────────────────────────────────────────┐
│ Messung am Leitungsanfang:                       │
│   •  Leiter-Erde-Spannungen                      │       21
│   •  (Nullspannung)                              │
│   •  Leiterströme                                │
│   •  (Nullstrom)                                 │
└─────────────────────────────────────────────────┘
```

**Bildung der symmetrischen Komponenten**   22

$$\underline{I}_0 = \frac{1}{3}\left(\underline{I}_R + \underline{I}_S + \underline{I}_T\right) \qquad \underline{U}_0 = \frac{1}{3}\left(\underline{U}_R + \underline{U}_S + \underline{U}_T\right)$$

$$\underline{I}_1 = \frac{1}{3}\left(\underline{I}_R + \underline{a}\cdot\underline{I}_S + \underline{a}^2\cdot\underline{I}_T\right) \qquad \underline{U}_1 = \frac{1}{3}\left(\underline{U}_R + \underline{a}\cdot\underline{U}_S + \underline{a}^2\cdot\underline{U}_T\right)$$

$$\underline{I}_2 = \frac{1}{3}\left(\underline{I}_R + \underline{a}^2\cdot\underline{I}_S + \underline{a}\cdot\underline{I}_T\right) \qquad \underline{U}_2 = \frac{1}{3}\left(\underline{U}_R + \underline{a}^2\cdot\underline{U}_S + \underline{a}\cdot\underline{U}_T\right)$$

**Berechnung des symmetrischen Nullstromes**   23

$$\underline{I}_{0\,s} = \underline{U}_0 \cdot \underline{Y}_{00-\text{Leitung}}$$

**Berechnung des Fehlerstromes**

$$\underline{I}_F = \underline{I}_0 - \underline{I}_{0\,s}$$

**Bildung der Differenzgrößen**   24

$$\Delta\underline{I}_{0\,s} = \underline{I}_{0\,s}(1) - \underline{I}_{0\,s}(2) \qquad \Delta\underline{U}_0 = \underline{U}_0(1) - \underline{U}_0(2)$$

$$\Delta\underline{I}_F = \underline{I}_F(1) - \underline{I}_F(2) \qquad \Delta\underline{U}_1 = \underline{U}_1(1) - \underline{U}_1(2)$$

$$\Delta\underline{I}_1 = \underline{I}_1(1) - \underline{I}_1(2) \qquad \Delta\underline{U}_2 = \underline{U}_2(1) - \underline{U}_2(2)$$

$$\Delta\underline{I}_2 = \underline{I}_2(1) - \underline{I}_2(2)$$

**Berechnung von Fehlerentfernung und Fehlerwiderstand**   25

$$l = \frac{\text{Im}\left(\dfrac{\Delta\underline{U}_1 + \Delta\underline{U}_2 + \Delta\underline{U}_0}{\Delta\underline{I}_F}\right)}{\text{Im}\left(\dfrac{(\Delta\underline{I}_1 + \Delta\underline{I}_2)}{\Delta\underline{I}_F}\cdot\underline{Z}'_{11}\right) + \text{Im}\left(\left(1 + \dfrac{\Delta\underline{I}_{0\,s}}{2\cdot\Delta\underline{I}_F}\right)\cdot\underline{Z}'_{00}\right)}$$

$$R_F = \frac{1}{3}\left(\text{Re}\left(\frac{\Delta\underline{U}_1 + \Delta\underline{U}_2 + \Delta\underline{U}_0}{\Delta\underline{I}_F}\right) - \text{Re}\left(\frac{(\Delta\underline{I}_1 + \Delta\underline{I}_2)}{\Delta\underline{I}_F}\cdot\underline{Z}'_{11}\right)\cdot l - \text{Re}\left(\left(1 + \frac{\Delta\underline{I}_{0\,s}}{2\cdot\Delta\underline{I}_F}\right)\cdot\underline{Z}'_{00}\right)\cdot l\right)$$